# EUROPEAN PATENT APPLICATION

(11) **EP 1 329 899 A2**
(43) Date of publication of application: **23.07.2003**
(21) Application number: 02027967.5
(22) Date of filing: 13.12.2002
(51) Int. Cl.: G11C 16/28, G11C 7/14

(54) **Semiconductor memory device, data processor, and method of determining frequency**

(30) Priority: 17.12.2001 JP 2001383045
(71) Applicant: NEC Electronics Corporation, Kawasaki, Kanagawa 211-8668 (JP)
(72) Inventor: Okamoto, Yuji, c/o NEC Micro Systems, Ltd., Kawasaki-shi, Kanagawa (JP)
(74) Representative: Glawe, Delfs, Moll & Partner

(57) **Abstract**

A semiconductor memory device includes: a plurality of memory cells from which memory data are successively read in synchronization with a read pulse that is received as input from the outside; at least one dummy cell from which dummy data are read in synchronization with the read pulse and a prescribed potential is used as a standard; a variable resistor element for delaying the transition to the prescribed potential in the dummy cell until a prescribed timing that precedes in time the timing of a prescribed edge of the read pulse having a prescribed pulse width, and an error output circuit for generating an error detection signal when the pulse width of the read pulse fluctuates and the transition to the prescribed potential comes after the timing of the prescribed edge.

## Description

### BACKGROUND OF THE INVENTION

### 1. Field of the Invention:

The present invention relates to a semiconductor memory device in which memory data is read in synchronization with a clock signal that is supplied from the outside and to a data processor having such a semiconductor memory device. The present invention further relates to a method of determining frequency that is carried out in such a semiconductor memory device.

### 2. Description of the Related Art:

RAM (Random Access Memory), ROM (Read Only Memory), and flash memory are known as semiconductor memory devices. In a data processor in which this type of memory is incorporated, the operations of reading data from and writing data to memory are controlled by, for example, a CPU (Central Processing Unit). The operations of reading data from and writing data to memory by a means such as a CPU is normally carried out in synchronization with a clock that serves as a reference.

In a semiconductor memory device in which reading data and writing data are carried out in synchronization with a clock signal as described above, the operations of reading and writing data cannot be carried out normally in some cases when fluctuations in the frequency of the clock signal that are caused by outside disturbance go beyond a permissible range (a range within which operations can be guaranteed). Semiconductor memory devices have therefore been proposed that are provided with a frequency determination circuit that can determine whether the frequency of the clock signal is higher or lower than a prescribed reference frequency in order to prevent malfunctioning.

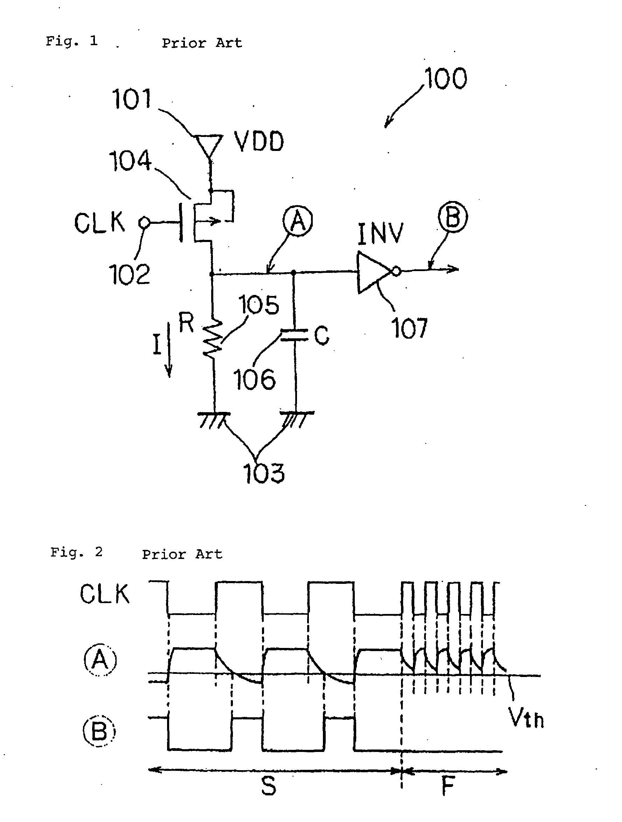

Japanese Patent Laid-open No. 288635/98 and Japanese Patent Laid-open No. 134605/99 disclose concrete configurations of the above-described frequency determination circuit. As one example, the construction of the frequency determination circuit that is described in Japanese Patent Laid-open No. 288635/98 is shown in FIG. 1.

Referring now to FIG. 1, frequency determination circuit 100 is a device for determining whether the frequency of clock signal CLK that is received as input from the outside is higher or lower than a prescribed reference frequency, and includes switching transistor 104 having a gate electrode that is connected to clock terminal 102 to which clock signal CLK is supplied. Switching transistor 104 has its source electrode connected to power supply terminal 101, to which power supply voltage V_{DD} is supplied; its drain electrode connected in parallel to resistor element 105, capacitor element 106, and inverter gate 107; and performs switching in accordance with clock signal CLK, which is supplied to its gate electrode. The other ends of resistor element 105 and capacitor element 106 are each connected to ground terminal 103.

A delay circuit is formed by resistor element 105 and capacitor element 106. Switching transistor 104, by performing switching in accordance with clock CLK, causes charging and discharging to be repeated in capacitor element 106 according to a prescribed time constant. Specifically, when switching transistor 104 turns ON, power supply voltage V_{DD} is supplied to capacitor element 106, capacitor element 106 is charged, and the potential in the input line of inverter gate 107 rises to power supply voltage V_{DD} at a slope that accords with a prescribed time constant. On the other hand, when switching transistor 104 turns OFF, the charge that has accumulated by charging capacitor element 106 flows to ground terminal 103, and the potential of the input line of inverter gate 107 falls as far as the ground potential at a slope that accords with the prescribed time constant. Inverter gate 107 produces a LOW-level signal as an output when the input voltage is higher than a predetermined threshold voltage "Vₜₕ" and produces a HIGH-level signal as an output when the input voltage is lower than the predetermined threshold voltage.

FIG. 2 shows the relation between clock signal CLK and the input/output in inverter gate 107 in the above-described frequency determination circuit 100. This example in FIG. 2 shows a case that is divided between an interval S in which the frequency of clock signal CLK is slower than the prescribed reference frequency and an interval F in which the frequency of clock signal CLK is faster than the reference frequency. In FIG. 2, A and B correspond to input A and output B of inverter gate 107, respectively, that is shown in FIG. 1.

The retained voltage of capacitor element 106 is the input voltage of inverter gate 107. As a result, the binary output in inverter gate 107 is switched according to whether the retained voltage of capacitor element 106 is higher or lower than threshold voltage "Vₜₕ."

As shown in FIG. 2, during interval S, charging of capacitor element 106 begins when switching transistor 104 turns ON at the falling edge of clock signal CLK. This charging causes the voltage of input A of inverter gate 107 to rise to power supply voltage V_{DD} that is higher than threshold voltage "Vₜₕ." Output B of inverter gate 107 becomes LOW-level at the time that the voltage of input A of inverter gate 107 exceeds threshold voltage "Vₜₕ."

Next, the discharge of capacitor element 106 begins when switching transistor 104 turns OFF at the rising edge of clock signal CLK. This discharge causes the voltage in input A of inverter gate 107 to become lower than threshold voltage "Vₜₕ" and eventually fall to the ground potential. Output B of inverter gate 107 becomes HIGH level at the time that the voltage of input A of inverter gate 107 becomes lower than threshold voltage "Vₜₕ."

The repetition of the above-described operation brings about the synchronization of the output B of inverter gate 107 with clock signal CLK.

During interval F, on the other hand, when switching transistor 104 turns OFF at the rising edge of clock signal CLK, the discharge of capacitor element 106 begins and the voltage in input A of inverter gate 107 falls. However, since the pulse width of clock signal CLK is narrow, switching transistor 104 turns ON at the falling edge of clock signal CLK before the voltage in input A of inverter gate 107 falls to threshold voltage "Vₜₕ." As a result, output B of inverter gate 107 is kept at LOW level.

According to the above-described operation, output B of inverter gate 107 switches cyclically between HIGH level and LOW level when the frequency of clock signal CLK is lower than the reference frequency, and output B of inverter gate 107 is maintained at LOW level when the frequency of clock signal CLK is higher than the reference frequency. As a result, monitoring of output B of inverter gate 107 enables the determination of whether the clock signal is higher or lower than the reference frequency.

When the above-described frequency determination circuit 100 is used in a semiconductor memory device, the maximum frequency and the minimum frequency of the clock signal are prescribed to be within a frequency range in which the semiconductor memory device will not malfunction; and frequency fluctuations in which the clock signal becomes higher than the maximum frequency or lower than the minimum frequency is then determined by frequency determination circuit 100. As an example, data reading and writing in the semiconductor memory device can be suspended when a frequency fluctuation has been determined by frequency determination circuit 100 so as to prevent malfunctions.

In a device of the prior art in which the above-described frequency determination circuit 100 is employed in a semiconductor memory device, changes in operating characteristics that result from fluctuations in the driving voltage (the power supply voltage), fluctuations in the ambient temperature, and fabrication errors will differ between the semiconductor memory device and frequency determination circuit 100. Normally, the operating characteristics of frequency determination circuit 100 exhibit greater variation, and as a result, it has been difficult to appropriately set the frequency that servers as the determination reference of frequency determination circuit 100 to the maximum frequency and minimum frequency of the semiconductor memory device. Even if the frequency that serves as the determination reference in frequency determination circuit 100 is set properly at the time of fabrication, the setting may become inappropriate after shipping depending on the environment in which the device is used.

Some semiconductor memory devices read memory data using a read pulse that is synchronized with a clock signal. In such cases, fluctuation in the pulse width of the read pulse prevents normal data reading, and some means of detecting variations in the pulse width of the read pulse was therefore necessary. In contrast with clock signal, which is generated constantly, the read pulse is generated only when memory data are read, and it has therefore been difficult to determine abnormalities in the read pulse (fluctuation in pulse width) in the above-described frequency determination circuit 100.

### SUMMARY OF THE INVENTION

It is an object of the present invention to provide a semiconductor memory device and a method of determining frequency that solve the above-described problems, and that can prevent malfunctioning at least when reading data.

It is another object of the present invention to provide a data processor that is provided with such a semiconductor memory device.

To realize the above-described objects, the first mode of the semiconductor memory device of the present invention includes:
a plurality of memory cells from which memory data are successively read in synchronization with a read pulse that is received as input from the outside;
at least one dummy cell unit from which dummy data are read in synchronization with the read pulse using a prescribed potential as a reference;
a delay means for delaying the transition to the prescribed potential in the dummy cell unit until a prescribed timing that precedes in time the timing of a prescribed edge of the read pulse having a prescribed pulse width; and
an abnormality detection means for generating an error detection signal when the pulse width of the read pulse fluctuates and the transition to the prescribed potential succeeds in time the timing of the prescribed edge.

According to the above-described first mode, the abnormality detection means generates an error detection signal when the pulse width of the read pulse narrows beyond a prescribed permissible range, whereby an abnormality in the read pulse can be detected. Moreover, the portion that is made up by the dummy cell unit, delay means, and abnormality detection means can be produced together on the substrate on which the portion for reading data from memory cells is formed, thereby eliminating the problem raised in the prior art regarding the differences that arise in the changes in operating characteristics as a result of changes in temperature, voltage fluctuation, and fabrication errors.

The second mode of the semiconductor memory device of the present invention includes:
a plurality of memory cells from which memory data are successively read in synchronization with a read pulse that is received as input from the outside; at least one dummy cell unit from which dummy data are read in synchronization with the read pulse using a prescribed potential as a reference;
a delay means for delaying the transition to the prescribed potential in the dummy cell unit until a prescribed timing that follows in time the timing of a prescribed edge of the read pulse having a prescribed pulse width; and
an abnormality detection means for generating an error detection signal when the pulse width of the read pulse fluctuates and the transition to the prescribed potential precedes in time the timing of the prescribed edge.

According to the above-described second mode, an abnormality in the read pulse can be detected because the abnormality detection means generates an error detection signal when the pulse width of the read pulse widens beyond a prescribed permissible range. In this case as well, the portion that is made up by the dummy cell unit, delay means, and abnormality detection means can be produced together on the substrate on which the portion for reading data from memory cells is formed, thereby eliminating the problem raised in the prior art regarding the differences that arise in changes in operating characteristics as a result of temperature changes, voltage fluctuation, and fabrication error.

The third mode of the semiconductor memory device of the present invention includes:
a plurality of memory cells from which memory data are successively read in synchronization with a read pulse that is received as input from the outside;
first and second dummy cell units from which dummy data are read in synchronization with the read pulse using a prescribed potential as reference;
a first delay means for delaying the transition to the prescribed potential in the first dummy cell unit until a prescribed timing that precedes in time the timing of a prescribed edge of the read pulse having a prescribed pulse width;
a second delay means for delaying the transition to the prescribed potential in the second dummy cell unit until a prescribed timing that follows in time the timing of the prescribed edge of the read pulse;
a first abnormality detection means for generating an error detection signal when the pulse width of the read pulse fluctuates and the transition to the prescribed potential in the first dummy cell unit follows in time the timing of the prescribed edge; and
a second abnormality detection means for generating an error detection signal when the pulse width of the read pulse fluctuates and the transition to the prescribed potential in the second dummy cell unit precedes in time the timing of the prescribed edge.

The above-described third mode provides the effects of both the first and second modes described above.

The data processor of the present invention includes:
a semiconductor memory device according to any one of the above-described first to third modes;
a clock generation means for generating a prescribed clock signal;
a data read means for generating a read pulse that is in synchronization with the clock signal and supplying the generated read pulse to the semiconductor memory device to read memory data; and
an operation control means for prohibiting reading of the memory data from the semiconductor memory device when the pulse width of the read pulse fluctuates and an error detection signal is sent from the semiconductor memory device.

The above-described constitution can provide a data processor that provides the effects of the above-described first to third modes.

The method of determining frequency of the present invention includes steps of:
reading dummy data from a prescribed dummy cell unit in synchronization with a read pulse that is received as input from the outside using a prescribed potential as reference;
delaying the transition to the prescribed potential in the prescribed dummy cell unit until a prescribed timing that precedes in time the timing of a prescribed edge of the read pulse having a prescribed pulse width; and
generating an error detection signal when the pulse width of the read pulse fluctuates and the transition to the prescribed potential is completed after the timing of the prescribed edge.

The above-described method of determining frequency also exhibits the same effects as the previously described first mode.

Another method of determining frequency of the present invention includes steps of:
reading dummy data from a prescribed dummy cell unit in synchronization with a read pulse that is received as input from the outside using a prescribed potential as reference;
delaying the transition to the prescribed potential in the prescribed dummy cell unit until a prescribed timing that follows in time the timing of a prescribed edge of the read pulse having a prescribed pulse width; and
generating an error detection signal when the pulse width of the read pulse fluctuates and the transition to the prescribed potential is completed before the timing of the prescribed edge.

The above-described method of determining frequency also exhibits the same effects as the previously described second mode.

The above and other objects, features, and advantages of the present invention will become apparent from the following description with reference to the accompanying drawings, which illustrate examples of the present invention.

### BRIEF DESCRIPTION OF THE DRAWINGS

Fig. 1 is a circuit diagram showing the internal construction of a frequency determination circuit that is used in a semiconductor memory device of the prior art.
FIG. 2 is a timing chart for explaining the operation of the frequency determination circuit shown in FIG. 1.
FIG. 3 is a block diagram showing the constitution of a mask ROM, which is the first working example of the semiconductor memory device of the present invention.
FIG. 4a is an equivalent circuit of a depletion-type transistor.
FIG. 4b is an operation characteristics chart of a depletion-type transistor.
FIG. 5a is an equivalent circuit of an enhancement-type transistor.
FIG. 5b is an operation characteristics chart of an enhancement-type transistor.
FIG. 6 is a circuit diagram for explaining reading of memory data in the mask ROM shown in FIG. 3.
FIG. 7 is a block diagram showing an example of the constitution of a data processor in which the mask ROM shown in FIG. 3 has been applied.
FIG. 8 is a timing chart for explaining the operation of the mask ROM shown in FIG. 3.
FIG. 9a is a circuit diagram showing an example of the constitution of error output circuit 317 that is shown in FIG. 3.
FIG. 9b is a circuit diagram showing an example of the constitution of error output circuit 318 shown in FIG. 3.

### DETAILED DESCRIPTION OF THE PREFERRED EMBODIMENTS

Working examples of the present invention are next described with reference to the accompanying drawings.

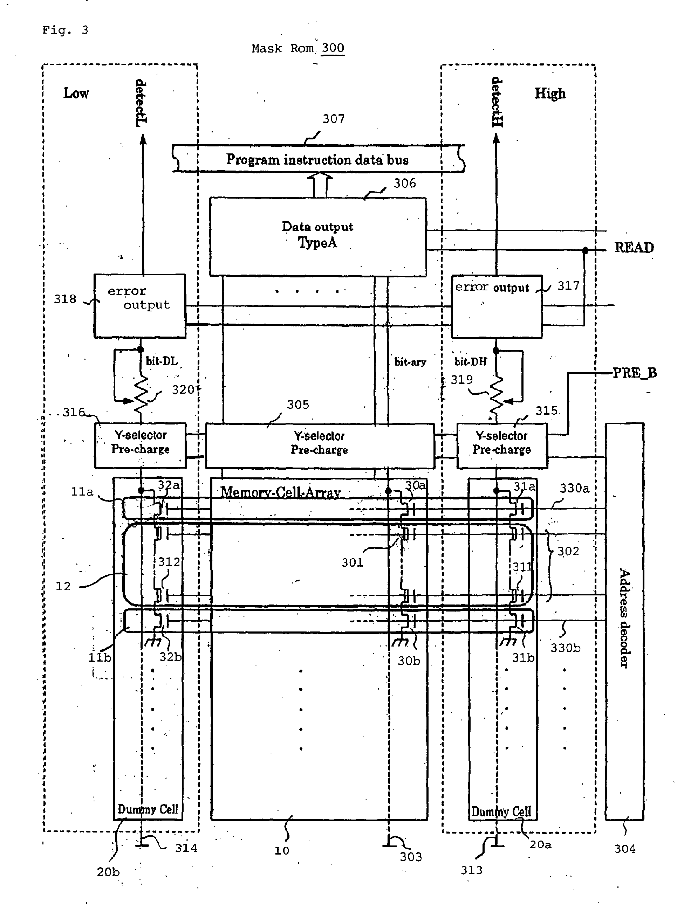

We refer first to FIG. 3, which is a circuit diagram that gives a schematic representation of the configuration of a mask ROM, which is a working example of the present invention. Referring to FIG. 3, mask ROM 300 of this working example includes: memory cell array 10 that includes a plurality of memory cells 301 in which information is stored according to data that are provided in advance from a user; and dummy cell units 20a and 20b that include a plurality of dummy cells 311 and 312 in which prescribed dummy data are stored. The entirety of this memory cell array 10 and dummy cell units 20a and 20b is divided into a plurality of blocks, each block being constituted by memory blocks 12 that can be selected by selection blocks 11a and 11b. Since the construction of each memory block 12 is the same, explanation will be given for one memory block 12.

Memory block 12 is made up by: m rows and n columns of memory cells 301 that are wired in a matrix by m word lines 302 and n bit lines 303 that mutually intersect; m dummy cells 311 that are arranged along dummy bit line 313; and m dummy cells 312 that are arranged along dummy bit line 314. Dummy bit lines 313 and 314 are arranged parallel to bit lines 303.

Each of memory cells 301 is made up by one transistor having a gate connected to word line 302, the transistors being connected in a series to adjacent transistors in the column direction. In other words, for each column, m transistors are connected in a series aligned along bit lines 303. Each of the lines in which transistors are connected in a series has one end connected to bit line 303 of the corresponding column by way of selection transistor 30a and the other end grounded by way of selection transistor 30b.

The m dummy cells are connected in a series, one end of the connected line being connected to dummy bit line 313 by way of selection transistor 31a and the other end being grounded by way of selection transistor 31b. Similarly, the m dummy cells 312 are also connected in a series, one end of the connected line being connected to dummy bit line 314 by way of selection transistor 32a and the other end being grounded by way of selection transistor 32b.

Each of selection transistors 30a and 31a has its gate connected in common to block selection line 330a that is arranged parallel to word line 302 to constitute selection block 11a. Similarly, each of selection transistors 30b and 31b has its gate connected in common to block selection line 330b that is arranged parallel to word line 302 to constitute selection block 11b.

The m word lines 302 and block selection lines 330a and 330b are connected to address decoder 304. The n bit lines 303 are connected via Y-selector 305 to data output circuit 306, which is a memory reading means. Data output circuit 306 is connected to data bus 307, and this data bus 307 is connected to the data output terminal of mask ROM 300.

Dummy bit line 313 is connected to error output circuit 317, which is provided with the dual capabilities of a first dummy read means and first abnormality detection means, by way of dummy cell Y-selector 315 and delay adjustment variable resistor element, which is the first delay means. Dummy bit line 314 is connected to error output circuit 318, which is provided with the dual capabilities of second dummy read means and second abnormality detection means, by way of dummy cell Y-selector 316 and delay-adjustment variable resistor element 320, which is the second delay means.

Y-selectors 305, 315, and 316 each incorporate a precharge circuit (not shown in the figure), and bit lines 303 and dummy bit lines 313 and 314 that are connected to each Y-selector can thus be precharged to a prescribed voltage by this precharge circuit. Precharging in these Y-selectors 305, 315, and 316 is synchronized with control pulse "pre_b" that is received as input from the outside.

Address decoder 304 is constituted to select one word line 302 from among the m word lines 302 in accordance with address data that are received as input from the outside. The combination of the selection operation that is realized by this address decoder 304 and the precharging operation realized by the above-described Y-selectors 305, 315, and 316 implements the selection of memory cells 301 in memory cell array 10 and the selection of dummy cells 311 and 312 in dummy cell units 20a and 20b.

Reading of memory data from the selected memory cells 301 is realized by data output circuit 306. The read operation that is realized by this data output circuit 306 is realized in synchronization with the read pulse "read" that is synchronized with clock signal "CK" (For example, a CPU clock) that is an externally generated reference. The above-described control pulse "pre_b" is synchronized with this read pulse "read." On the other hand, the reading of dummy data from selected dummy cells 311 and 312 is carried out by error output circuits 317 and 318, respectively. The read operation performed by these error output circuits 317 and 318 is also basically carried out in synchronization with read pulse "read."

In mask ROM of this working example, the transistors that constitute memory cells 301 of this memory cell array are set to either a depletion state (conductive) or an enhancement state (nonconductive), and memory data, which correspond to "0" and "1" according to the difference in these states, are stored in advance. The reading of memory data is carried out by using the difference between the depletion state and enhancement state to establish a correlation between "0" and "1" of data and conduction and nonconduction between bit lines and ground.

Basic operations for reading memory data are next explained.

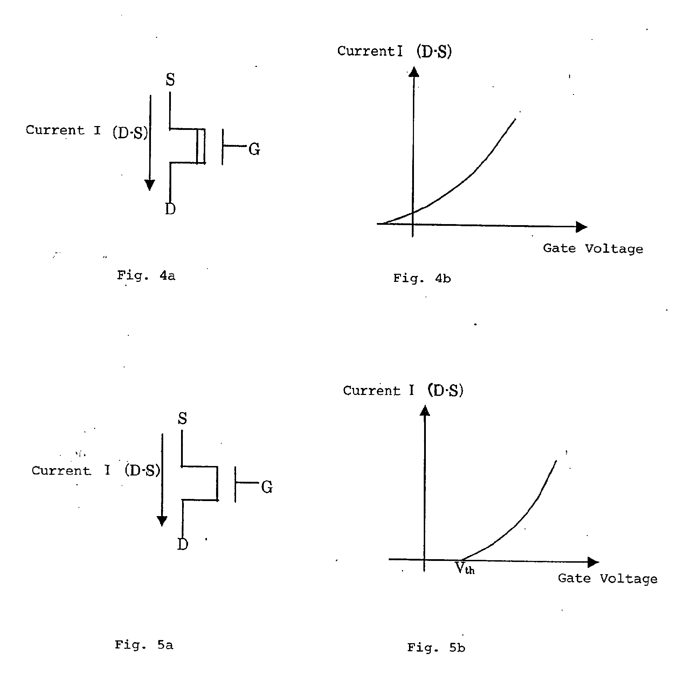

FIG. 4(a) shows an equivalent circuit of a depletion-type transistor, and FIG. 4(b) shows the characteristics of this transistor. This transistor has phosphorus ions doped in the n-channel region between the source and drain, and current therefore flows across the source and drain even when the gate voltage is 0V.

FIG. 5(a) shows an equivalent circuit of an enhancement-type transistor, and FIG. 5(b) shows the characteristics of this transistor. Unlike the previously described transistor, this transistor does not have phosphorus ions doped in the n-channel region between the source and drain, and current therefore flows across the source and drain only when a voltage exceeding the threshold voltage Vth is supplied to the gate.

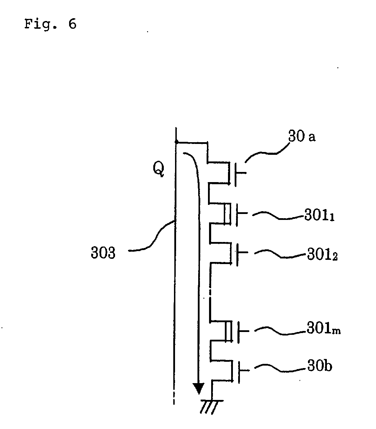

As shown in FIG. 3, the m memory cells 301 (transistors) that are aligned along bit line 303 are connected in a series in the memory cell array, one end of this connected line being connected to bit line 303 by way of selection transistor 30a, and the other end being grounded by way of selection transistor 30b. FIG. 6 gives a schematic representation of the flow of charge when reading memory data from a memory cell that is connected to one bit line.

Referring now to FIG. 6, transistors 301₁-301ₘ that correspond to m memory cells 301 are connected in a series, one end of this connected line being connected to bit line 303 by way of selection transistor 30a, and the other end being grounded by way of selection transistor 30b. In this example, only transistor 301₂ is enhancement-type (nonconductive), the other transistors 301₁ and 301₃-301ₘ being depletion-type (conductive). When reading memory data, all of these transistors 301₁-301ₘ are set to the ON state.

When reading memory data from transistor 301₁, selection transistors 30a and 30b are first turned OFF and bit line 303 is precharged. This precharging causes charge Q to be accumulated in bit line 303. Transistor 301₁ that had been set ON is next turned OFF at the same time that selection transistors 30a and 30b are turned ON. Since transistor 301₁ is a depletion-type transistor, current flows across the source and drain even when the transistor is OFF. In this state, the other transistors 301₂-301ₘ are kept in the ON state and a conductive state is established between bit line 303 and ground, whereby charge Q that has accumulated in bit line 303 flows toward ground through transistors 301₁-301ₘ as shown in FIG. 6. As a result, the potential in bit line 303 becomes the ground potential.

When reading memory data from transistor 301₂, selection transistors 30a and 30b are first turned OFF and bit line 303 is precharged. This precharging causes charge Q to be accumulated in bit line 303. Transistor 301₂, which had been set to the ON state, is next turned OFF at the same time that selection transistors 30a and 30b are turned ON. Since transistor 301₂ is an enhancement-type transistor, no current flows across the source and drain when it is OFF. In this state, a nonconductive state exists between bit line 303 and ground, and charge Q that has accumulated is maintained in bit line 303.

Reading is performed with "0" or "1" of data corresponding to whether the potential of bit line 303 is the ground potential or a potential resulting from the remaining charge Q (normally, equivalent to the power supply voltage). For example, if "0" is for a case in which the potential of bit line 303 is the ground potential and "1" is for a case in which the potential of bit line 303 is a potential resulting from charge Q, memory data "0" is read from transistor 301₁ and memory data "1" is read from transistor 301₂.

Memory data are read from the other transistors 301₃-301ₘ according to the same principles as described above.

Explanation next regards the basic operations of reading dummy data from dummy cell units 20a and 20b. This reading of dummy data is performed in order to detect abnormalities in the pulse width of read pulse "read" and is carried out in synchronization with the reading of memory data from the above-described memory cells. Both of the transistors that constitute dummy cells 311 and 312 are depletion-type transistors, and current therefore always flows across the source and drain regardless of the ON or OFF state of the transistor. In addition, regarding synchronization with the above-described reading of memory data, the transistors that constitute dummy cells 311 and 312 are all set to the ON state when reading this dummy data.

When reading dummy data from dummy cell 311 of dummy cell unit 20a, selection transistors 31a and 31b are first turned OFF and dummy bit line 313 is precharged. This precharging causes charge Q to be accumulated in dummy bit line 313. Dummy cell 311 that is connected to word line 302, which is connected to memory cell 301 from which memory data are to be read, is turned OFF at the same time that selection transistors 31a and 31b are turned ON. All of dummy cells 311 of dummy cell unit 20a are depletion-type transistors, and a conductive state therefore exists between dummy bit line 313 and ground, whereby charge Q that has accumulated in dummy bit line 313 flows to ground (discharges). As a result, the potential in dummy bit line 313 gradually falls to finally become the ground potential.

Normally (when the width of read pulse "read" is within the range that allows normal reading of memory data), the potential when dummy bit line 313 is at the above-described ground potential (actually, 0V) is read. as dummy data at the timing of the reading of memory data.

Basically, the above-described precharging and discharging in dummy bit line 313 is performed in synchronization with read pulse "read." When the amount of charge Q that has accumulated in dummy bit line 313 due to precharging is constantly uniform regardless of the pulse width of read pulse "read," the time T for the potential in dummy bit line 313 to fall as far as the ground potential is also constantly uniform regardless of the pulse width of read pulse "read." Abnormalities in the pulse width of read pulse "read" can therefore be detected by taking advantage of this uniformity, as described below.

By adjusting time T, the transition to ground potential in dummy bit line 313 is delayed until a prescribed timing that precedes in time a prescribed edge of read pulse "read" (this being the timing of the above-described reading of memory data) when read pulse "read" has a prescribed pulse width. Here, the prescribed pulse width should be within a range in which malfunctions do not occur in the reading of memory data (the permissible range). In addition, the prescribed timing should also be set to a timing that is within the permissible range, and moreover, that precedes in time the above-described prescribed edge of read pulse "read." Time T can be freely adjusted by means of the resistance of variable resistor element 319.

According to the above-described setting, when a pulse width of read pulse "read" is within the permissible range, the dummy data are read after dummy bit line 313 reaches the ground potential. In this case, the data that correspond to the ground potential, for example, the LOW-level signal, are obtained as the dummy data. On the other hand, when the pulse width of read pulse "read" narrows beyond the above-described permissible range, the dummy data are read before dummy bit line 313 reaches the ground potential. In this case, data that correspond to the potential that results from charge Q that remains in dummy bit line 313, for example, a HIGH-level signal, are obtained as the dummy data. Abnormalities in the pulse width of read pulse "read" can be detected based on the LOW-level signal and HIGH-level signal that are obtained in this way.

The reading of dummy data from dummy cell 311 of dummy cell unit 20b is basically the same as the above-described reading of dummy data from dummy cell 311 in dummy cell unit 20a. In this case, however, variable resistor element 320 is used to adjust time T to delay the transition to the ground potential in dummy bit line 314 until a prescribed timing that follows in time the prescribed edge of read pulse "read" (this being the timing of reading the above-described memory data) when read pulse "read" has a prescribed pulse width.

According to the above-described settings, dummy data are read before dummy bit line 314 reaches the ground potential when the pulse width of read pulse "read" is within the permissible range. In this case, data that correspond to the potential resulting from remaining charge Q, for example, a HIGH-level signal, are obtained as dummy data. When the pulse width of read pulse "read" widens and deviates from the permissible range, on the other hand, dummy data are read after dummy bit line 314 reaches the ground potential. In this case, data that correspond to the ground potential, for example, a LOW-level signal, are obtained as the dummy data. Abnormalities in the pulse width of read pulse "read" can be detected based on the LOW-level signal and HIGH-level signal that are obtained in this way.

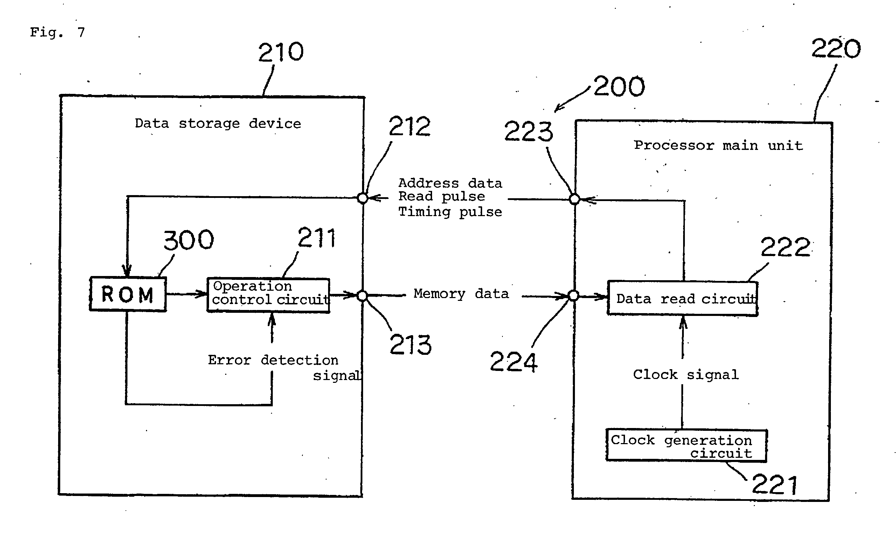

Explanation next regards the constitution of a data processor in which ROM 300 of the present working example is applied. FIG. 7 shows an example of the constitution of this data processor.

Referring now to FIG. 7, data processor 200 includes: data storage device 210 in which ROM 300 is incorporated; and processor main unit 220 for reading data from ROM 300. Data storage device 210 is of a construction that allows attachment to and detachment from processor main unit 220.

Apart from ROM 300, data storage device 210 includes: operation control circuit 211, which is the operation control means; signal input terminal 212; and data output terminal 213. Processor main unit 220 includes: clock generation circuit 221, which is the clock generation means; data read circuit 222, which is the data read means; signal output terminal 223; and data input terminal 224.

When data storage device 210 is installed in processor main unit 220, signal input terminal 212 is connected to signal output terminal 223, and data output terminal 213 is connected to data input terminal 224.

Clock generation circuit 221 is composed of, for example, a crystal oscillator (not shown in the figure), generates a clock signal "CK" of a prescribed cycle, and supplies this clock signal "CK" to data read circuit 222. Data output circuit 222 is composed of, for example, a CPU, and supplies various pulse signals that are synchronized with clock signal "CK" and that are necessary to reading data from mask ROM 300 to signal output terminal 223 to obtain data from mask ROM 300.

Signals that are necessary for reading data from mask ROM 300 include address data of the memory data, control pulse "pre_b" for designating the timing of executing precharging, read pulse "read" for designating the timing of reading memory data, and timing pulse "Tim0" for designating the timing of detecting speed abnormalities of the read pulse. When these signals are supplied in mask ROM 300, the previously described operations for reading memory data and dummy data and operations for detecting abnormalities in the pulse width of read pulse "read" are carried out.

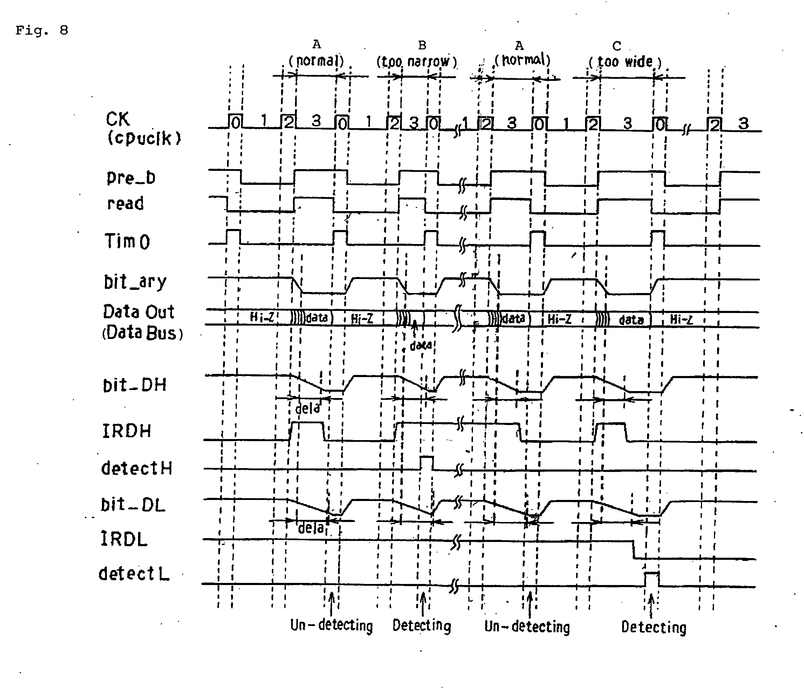

FIG. 8 is a timing chart for explaining the operation for reading memory data and dummy data and the operation for detecting abnormalities in the pulse width of read pulse "read" in mask ROM 300. In FIG. 8, the cycle of control pulse "pre_b" and read pulse "read" is double the cycle of clock signal CK. The interval of the LOW level of control pulse "pre_b" matches the interval "1-2" of clock signal CK, and the interval of the HIGH level matches the interval "3-0" of clock signal CK. The interval of the LOW level of read pulse "read" matches the interval "0-2" of clock signal CK, and the interval of the HIGH level matches the interval "3" of clock signal CK. Timing pulse "Tim0" is obtained by separating the synchronization of interval "0" of the clock signal. Interval A indicates a case in which the pulse width of read pulse "read" is normal, interval B indicates a case in which the pulse width of read pulse "read" narrows beyond the permissible range, and interval C indicates a case in which the pulse width of read pulse "read" widens beyond the permissible range. The example shown in FIG. 8 shows two operating forms: one of change from interval A to interval B, and one of change from interval A to interval C.

Referring now to Figs. 3, 7, and 8, the operation of data storage device 210 and the details of the operation of mask ROM 300 are next explained.

### (1) Operation of Data Storage Device 210

When each of the above-described types of pulses are applied as input from signal input terminal 212 in mask ROM 300, memory data that corresponds to address data are read in synchronization with the read pulse and applied to data output terminal 213. When reading memory data, mask ROM 300 determines abnormalities in the pulse width of read pulse "read," and when an abnormality has been determined, mask ROM 300 applies an error detection signal "detect H/L" that reports this fact to operation control circuit 211 in synchronization with timing pulse "Tim0."

Operation control circuit 211 is constituted by a dedicated logical circuit, and upon the input of at least one error detection signal "detect H/L" from mask ROM 300, prohibits the reading of data from mask ROM 300 to data read circuit 222. This prohibition of data reading is realized by, for example, cutting off the data line between mask ROM 300 and data output terminal 213.

### (2) Detailed Operation of Mask ROM 300

The operations in one memory block 12 shown in FIG. 3 are here described divided into interval A, interval B, and interval C. In the interest of simplifying the explanation of operations, all memory cells 311 of memory cell array 10 in the above-described memory block 12 are assumed to be of the depletion type.

### (2-1) Interval A

First, in accordance with the address data, address decoder 304 selects one word line from m word lines 302 and Y-selector 305 selects one bit line from n bit lines (the selected bit line is referred to as "selected bit line BL"), whereby the memory cell that have been designated by the address data (the designated memory cell is hereinbelow referred to as "designated memory cell MC") is selected. Y-selector 305 next precharges the selected bit lines BL at the timing of the falling edge of control pulse "pre_b" and Y-selectors 315 and 316 precharge dummy bit lines 313 and 314, respectively. The precharging of these bit lines 303 and dummy bit lines 313 and 314 is carried out as previously described (refer to FIG. 6).

Next, at the timing of the rising edge of control pulse "pre_b", address decoder 304 turns ON selection transistors 30a and 30b that are connected to the selected bit line BL and turns ON selection transistors 31a and 31b that are connected to dummy bit lines 313 as well as selection transistors 32a and 32b that are connected to dummy bit lines 314, whereby the charge that has accumulated by precharging in the selected bit line BL flows toward ground and the potential of the selected bit line BL (potential "bit_ary" in FIG. 8) becomes the ground potential. Similarly, the charge that has accumulated in dummy bit lines 313 and 314 due to precharging flows toward ground and the potential of each ("bit_DH" and "bit_DL" in FIG. 8) becomes the ground potential. The transitions toward the ground potential in the selected bit line BL and dummy bit line 313 both precede the timing of the falling edge of read pulse "read." On the other hand, the transition to the ground potential in dummy bit line 314 follows the timing of the falling edge of read pulse "read."

Next, at the timing of the falling edge of read pulse "read," data output circuit 306 reads data that accords with potential "bit_ary" of the selected bit line BL as the memory data of the designated memory cell MC, and simultaneously, error output circuits 317 and 318 read the data that accords with the potential "bit_DH" and "bit_DL" of dummy bit lines 313 and 314 as dummy data and determine that read pulse "read" is abnormal based on the dummy data that are read.

The specific construction of error output circuits 317 and 318 is next explained.

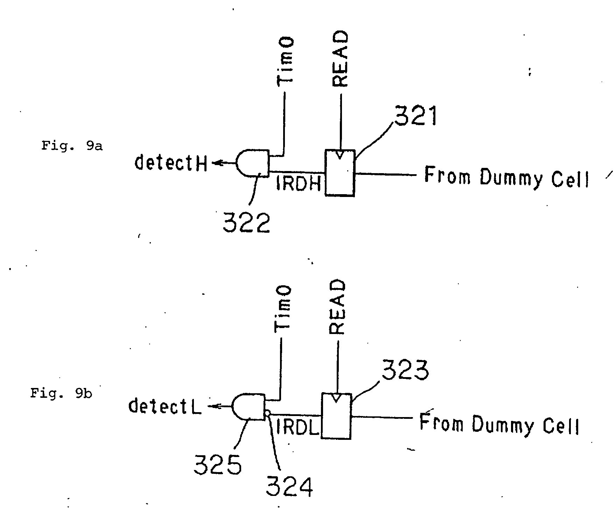

As shown in FIG. 9(a), error output circuit 317 is composed of: latch circuit 321 that latches the level of potential "bit_DH" of dummy bit line 313 at the timing of the rising edge and falling edge of read pulse "read"; and AND gate 322 that takes the logical product of the output of this latch circuit 321 ("IRDH" in FIG. 8) and timing pulse "Tim0".
(a) If the transition to the ground potential in dummy bit line 313 precedes the timing of the falling edge of read pulse "read", output "IRDH" of latch circuit 321 at the falling edge of read pulse "read" is "0" and output "detectH" of AND gate 322 is "0."
(b) On the other hand, if the transition to ground potential in dummy bit line 313 follows the timing of the falling edge of read pulse "read," output "IRDH" of latch circuit 321 at the time of the falling edge of read pulse "read" is "1," and output "detectH" of AND gate 322 is "1."
   When the pulse width of read pulse "read" is normal (when the pulse width is within the permissible range), the above-described state (a) is obtained; and when an abnormality occurs in the pulse width of read pulse "read" (when the pulse width narrows beyond the permissible range), the above-described state (b) is obtained. Accordingly, an abnormality in the pulse width of read pulse "read" (a state in which the pulse width narrows beyond the permissible range) can be detected by monitoring whether output "detectH" of AND gate 322 is "0" or "1."
   As shown in FIG. 9(b), error output circuit 318 is composed of: latch circuit 323 that latches the level of potential "bit_DL" of dummy bit line 314 at the timing of the rising edge and falling edge of read pulse "read"; and AND gate 325 that receives the inverted output of this latch circuit 323 and that takes the logical product of the received inverted value and timing pulse "Tim0."
(c) When the transition to the ground potential in dummy bit line 314 follows the timing of the falling edge of read pulse "read," output "IRDL" of latch circuit 323 at the time of the falling edge of read pulse "read" is "1," and output "detectL" of AND gate 325 is "0."
(d) On the other hand, when the transition to the ground potential in dummy bit line 314 precedes the timing of the falling edge of read pulse "read," output "IRDL" of latch circuit 323 at the time of the falling edge of read pulse "read" becomes "0" and output "detectL" of AND gate 325 becomes "1."

When the pulse width of read pulse "read" is normal (when the pulse width is within the permissible range), the above-described state (c) is obtained, and when an abnormality occurs in the pulse width of read pulse "read" (when the pulse width widens beyond the permissible range), the above-described state (d) is obtained. Accordingly, an abnormality in the pulse width of read pulse "read" (a state in which the pulse width has widened beyond the permissible range) can be detected according to whether output "detectL" of AND gate 325 is "0" or "1."

In interval A, the pulse width of read pulse "read" is normal, and output "detectH" of AND gate 322 and output "detectL" of AND gate 325 are therefore both "0." As a result, error output circuits 317 and 318 do not send an error detection signal.

### (2-2) Interval B

The operations of this interval B are operations in a state in which the pulse width of read pulse "read" has narrowed beyond the permissible range. Since the operations for reading memory data and dummy data are equivalent to the above-described operations of "(2-1) Interval A," explanation regarding the read operation is here omitted, and explanation will be limited to the distinctive operations for detecting an abnormality in read pulse "read."

When the pulse width of read pulse "read" narrows beyond the permissible range, the transition to the ground potential in dummy bit line 313 comes after the timing of the falling edge of read pulse "read," whereby output "IRDH" of latch circuit 321 at the time of the fall of read pulse "read" becomes "1" and output "detectH" of AND gate 322 becomes "1" (as with the above-described state (b)). On the other hand, the transition to ground potential in dummy bit line 314 comes after the timing of the falling edge of read pulse "read," whereby output "IRDL" of latch circuit 323 becomes "1" at the time of the fall of read pulse "read" and output "detectH" of AND gate 322 becomes "0." As a result, an error detection signal is transmitted only from error output circuit 317 in interval B.

### (2-3) Interval C

Operations during this interval C are operations in a state in which the pulse width of read pulse "read" has widened beyond the permissible range. Since the operations for reading memory data and dummy data are basically equivalent to the above-described case "(2-1) Interval A," explanation regarding the read operation is here omitted, and explanation will be limited to the distinctive operations for detecting abnormality in read pulse "read."

When the pulse width of read pulse "read" widens beyond the permissible range, the transition to the ground potential in dummy bit line 314 precedes the timing of the falling edge of read pulse "read," whereby output "IRDL" of latch circuit 323 becomes "0" at the time of the fall of read pulse "read" and output "detectL" of AND gate 325 becomes "1." On the other hand, the transition to the ground potential in dummy bit line 313 precedes the timing of the falling edge of read pulse "read," whereby output "IRDH" of latch circuit 321 at the time of the fall of read pulse "read" becomes "0" and output "detectH" of AND gate 322 becomes "0." As a result, an error detection signal is transmitted only from error output circuit 318 in interval C.

As described in the foregoing explanation, the ability to detect abnormalities in the pulse width of the read pulse enables the prevention of malfunctions when reading memory data in mask ROM of the present working example.

In addition, since the read pulse is synchronized with the clock signal, mask ROM 300 of this working example can indirectly detect an abnormality in the clock signal. Since the read pulse matches interval "3" of the clock signal in this case, as shown in FIG. 8, at least one of the frequency and the duty ratio (the ratio of the HIGH-level interval to the LOW-level interval) of the clock signal fluctuates and interval "3" changes, and mask ROM 300 can detect this change as an abnormality of the pulse width of the read pulse.

When both the frequency and duty ratio of the clock signal fluctuate and the above-described change in interval "3" does not occur, mask ROM 300 is not able to detect this change as an abnormality in the read pulse. In this case, however, the pulse width of the read pulse is normal, and no malfunctions will occur in reading data in mask ROM 300.

Mask ROM 300 is constituted to detect abnormalities in the read pulse that play a direct role in data reading in mask ROM 300, and mask ROM 300 can therefore detect an abnormality in the read pulse and prevent malfunctioning in data reading when, for example, the read pulse becomes abnormal due to outside disturbance when the clock signal is in a normal state.

In addition, mask ROM 300 detects abnormalities in the read pulse through the use of dummy cells that have the same structure as memory cells, and moreover, that are formed on the same substrate. This construction can eliminate the previously described problem of the prior art in which the changes in operation characteristics, which result from factors such as temperature changes, voltage fluctuation, fabrication error, differ for the portion for reading data from memory cells and the portion that uses dummy cells for detecting pulse abnormalities. As a result, appropriate settings can be easily implemented with due consideration given to the conditions of use.

In addition, the adoption of identical construction for the memory cells and dummy cells allows these memory cells and dummy cells to be fabricated by identical fabrication processes whereby a reduction in costs can be obtained.

Further, because dummy cells are arranged for each row of memory cells arranged in matrix form, the influence upon data reading caused by specific fabrication errors can be made to coincide in the row direction, and malfunctions can therefore be more reliably prevented when reading data. Specific fabrication errors include, for example, errors that occur when using optics to expose patterns in a lithographic process of wafer processing.

In addition, the delay means for determining the transition to the ground potential in dummy bit lines is constituted by a variable resistor element. This constitution enables delaying the transition to the ground potential by a desired time interval by means of a simple construction.

The mode as described in the foregoing explanation is the first embodiment of the present invention, and the constitution of this mode is open to appropriate modifications as long as such modifications do not depart from the essential point, which resides in the use of dummy cells to detect abnormalities of a signal such as a read pulse. In the above-described mode, for example, a mask ROM was taken as an example of a semiconductor memory device of the present invention, but the present invention may also be applied to memory other than mask ROM such as PROM (Programmable ROM), EPROM (Erasable PROM), EEPROM (Electrically EPROM), RAM, and flash memory.

Further, the mode shown in FIG. 3 included the two circuits: a first pulse determination unit composed of dummy bit line 313, dummy cell unit 20a, Y-selector 315, variable resistor element 319, and error output circuit 317; and a second pulse determination unit composed of dummy bit line 314, dummy cell unit 20b, Y-selector 316, variable resistor element 320, and error output circuit 318; but the present invention is not limited to this form and may be a construction provided with only one of the first and second pulse determination units according to the environment of use or setting conditions. Such a construction would allow a semiconductor memory device to be provided at a lower cost.

In addition, processor main unit 220 and data storage device 210 in data processor 200 shown in FIG. 7 may be a monolithic structure. Further, data read circuit 222 may be loaded on the data storage device 210 side and operation control circuit 211 may be loaded on processor main unit 220. Finally, a configuration is also possible in which operation control circuit 211 forcibly halts the overall operation of data processor 200, including the operation of data read circuit 222 or clock generation circuit 221, when an error detection signal is transmitted from mask ROM 300.

While a preferred embodiment of the present invention has been described using specific terms, such description is for illustrative purposes only, and it is to be understood that changes and variations may be made without departing from the spirit or scope of the following claims.

## Claims

1. A semiconductor memory device, comprising:
a plurality of memory cells from which memory data are successively read in synchronization with a read pulse that is received as input from the outside;
at least one dummy cell unit from which dummy data are read in synchronization with said read pulse using a prescribed potential as reference;
a delay means for delaying the transition to said prescribed potential in said dummy cell unit until a prescribed timing that precedes in time the timing of a prescribed edge of said read pulse having a prescribed pulse width; and
abnormality detection means for generating an error detection signal when the pulse width of said read pulse fluctuates and the transition to said prescribed potential succeeds in time the timing of said prescribed edge.

2. A semiconductor memory device, comprising:
a plurality of memory cells from which memory data are successively read in synchronization with a read pulse that is received as input from the outside;
at least one dummy cell unit from which dummy data are read in synchronization with said read pulse using a prescribed potential as reference;
a delay means for delaying the transition to said prescribed potential in said dummy cell unit until a prescribed timing that follows in time the timing of a prescribed edge of said read pulse having a prescribed pulse width; and
abnormality detection means for generating an error detection signal when the pulse width of said read pulse fluctuates and the transition to said prescribed potential precedes in time the timing of said prescribed edge.

3. A semiconductor memory device according to claim 1 or claim 2, wherein said dummy cell unit includes at least one dummy cell that has the same structure as said plurality of memory cells.

4. A semiconductor memory device according to any one of claims 1 to 3,
further comprising dummy bit lines in which charge is accumulated by supplying prescribed voltage, and in which discharge is carried out in which said accumulated charge flows toward ground when said dummy data are read;
wherein the transition to said prescribed potential in said dummy cell unit is a state in which said discharge causes the potential in said dummy bit line to become the ground potential.

5. A semiconductor memory device according to any one of claims 1 to 4, wherein said plurality of memory cells store prescribed data in advance.

6. A semiconductor memory device according to claim 5, wherein each of said plurality of memory cells is constituted by one transistor, and information is stored depending on whether or not prescribed ions have been implanted in the channel region between the source and drain of each transistor to produce a conductive state.

7. A semiconductor memory device according to claim 5, wherein said plurality of memory cells are arranged in rows and columns, and wherein said dummy cell unit has one dummy cell arranged for each row of said plurality of memory cells; further comprising:
memory read means for reading memory data for each row of said memory cells; and
dummy read means for, when memory data are read by said memory read means, reading dummy data from said dummy cells that are provided in rows in which said memory data are read.

8. A semiconductor memory device, comprising: a plurality of memory cells from which memory data are successively read in synchronization with a read pulse that is received as input from the outside;
first and second dummy cell units from which dummy data are read in synchronization with said read pulse using a prescribed potential as reference;
a first delay means for delaying the transition to said prescribed potential in said first dummy cell unit until a prescribed timing that precedes in time the timing of a prescribed edge of said read pulse having a prescribed pulse width;
a second delay means for delaying the transition to said prescribed potential in said second dummy cell unit until a prescribed timing that follows in time the timing of said prescribed edge of said read pulse;
a first abnormality detection means for generating an error detection signal when the pulse width of said read pulse fluctuates and the transition to said prescribed potential in said first dummy cell unit follows in time the timing of said prescribed edge; and
second abnormality detection means for generating an error detection signal when the pulse width of said read pulse fluctuates and the transition to said prescribed potential in said second dummy cell unit precedes in time the timing of said prescribed edge.

9. A semiconductor memory device according to claim 8, wherein said first and second dummy cell units includes at least one dummy cell that has the same structure as said plurality of memory cells.

10. A semiconductor memory device according to claim 8 or claim 9, further comprising a first and second dummy bit lines in which charge is accumulated by supplying a prescribed voltage; wherein:
said first dummy bit line is used for a first discharge by which said accumulated charge flows toward ground when dummy data are read from said first dummy cell unit;
said second dummy bit line is used for a second discharge by which said accumulated charge flows toward ground when dummy data are read from said second dummy cell unit;
the transition to said prescribed potential in said first dummy cell unit is a state in which said first discharge causes the potential in said first dummy bit line to become the ground potential; and
the transition to said prescribed potential in said first dummy cell unit is a state in which said second discharge causes the potential in said second dummy bit line to become the ground potential.

11. A semiconductor memory device according to any one of claims 8 to 10, wherein said plurality of memory cells store prescribed data in advance.

12. A semiconductor memory device according to claim 11, wherein each of said plurality of memory cells is constituted by one transistor, and information is stored depending on whether or not prescribed ions have been implanted in the channel region to produce a conductive state between the source and drain of each transistor.

13. A semiconductor memory device according to claim 11, wherein said plurality of memory cells are arranged in rows and columns, and wherein said first and second dummy cell units each have one dummy cell arranged for each row of said plurality of memory cells; further comprising:
memory read means for reading memory data for each row of said memory cells; and
dummy read means for, when memory data are read by said memory read means, reading dummy data from said dummy cells that are provided in rows in which said memory data are read.

14. A semiconductor memory device according to any one of claims 1 to 13, wherein said delay means is constituted by a variable resistor element.

15. A data processor, comprising:
a semiconductor memory device according to any one of claims 1 to 14;
a clock generation means for generating a prescribed clock signal;
a data read means for generating a read pulse that is in synchronization with said clock signal and supplying the generated read pulse to said semiconductor memory device to read memory data; and
operation control means for prohibiting reading of said memory data from said semiconductor memory device when the pulse width of said read pulse fluctuates and an error detection signal is sent from said semiconductor memory device.

16. A data processor according to claim 15, wherein said operation control means forces operation of the entire data processor to terminate when an error detection signal is sent from said semiconductor memory device.

17. A method of determining frequency, comprising steps of:
reading dummy data from a prescribed dummy cell unit in synchronization with a read pulse that is received as input from the outside and using a prescribed potential as reference;
delaying the transition to said prescribed potential in said prescribed dummy cell unit until a prescribed timing that precedes in time the timing of a prescribed edge of said read pulse having a prescribed pulse width; and
generating an error detection signal when the pulse width of said read pulse fluctuates and the transition to said prescribed potential is completed after the timing of said prescribed edge.

18. A method of determining frequency, comprising steps of:
reading dummy data from a prescribed dummy cell unit in synchronization with a read pulse that is received as input from the outside and using a prescribed potential as reference;
delaying the transition to said prescribed potential in said prescribed dummy cell unit until a prescribed timing that follows in time the timing of a prescribed edge of said read pulse having a prescribed pulse width; and
generating an error detection signal when the pulse width of said read pulse fluctuates and the transition to said prescribed potential is completed before the timing of said prescribed edge.
